**Europäisches Patentamt**

**European Patent Office**

**Office européen des brevets**

(11) Publication number: **0 144 900**
**B1**

# EUROPEAN PATENT SPECIFICATION

(45) Date of publication of patent specification: **13.06.90**

(21) Application number: **84114348.0**

(22) Date of filing: **27.11.84**

(51) Int. Cl.⁵: **H 01 L 29/60, H 01 L 21/28, H 01 L 21/82**

(54) An electrically programmable memory device and a method for making the same.

(30) Priority: **28.11.83 US 556028**

(43) Date of publication of application:
**19.06.85 Bulletin 85/25**

(45) Publication of the grant of the patent:
**13.06.90 Bulletin 90/24**

(84) Designated Contracting States:
**BE DE FR GB IT NL**

(56) References cited:
**FR-A-2 468 185**
**US-A-3 996 657**
**US-A-4 203 158**
**US-A-4 355 455**

**IEEE JOURNAL OF SOLID-STATE CIRCUITS, vol. SC-18, no. 5, October 1983, pages 532-538, IEEE, New York, US; D.H. OTO et al.: "High-voltage regulation and process considerations for high-density 5 V-only E2PROM's"**

(73) Proprietor: **EXEL MICROELECTRONICS, INC.**
**2150 Commerce Drive**
**San Jose, Cal. 95131 (US)**

(72) Inventor: **Chang, Thomas T. L.**
**3474 Bonita Avenue**
**Santa Clara Cal. 95051 (US)**
Inventor: **Ho, Chun**
**10431 North Blaney Avenue**
**Cupertino Cal. 95014 (US)**
Inventor: **Malhotra, Arun Kumar**
**707 Continental Circla 632**
**Mt. View Cal. 94040 (US)**

(74) Representative: **Blumbach Weser Bergen Kramer Zwirner Hoffmann Patentanwälte**
**Sonnenberger Strasse 100**
**D-6200 Wiesbaden (DE)**

## Description

The present invention relates to an electrically programmable device and a method for making the same. The electrically programmable memory device can be of the type that is commonly called Electrically Programmable Read-Only Memory (EPROM) or Electrically Erasable Programmable Read-Only memory (EEPROM). More particularly, the present invention relates to the manufacture of ultra high coupling interpoly dielectrics suitable for programming EEPROM and EPROM devices at faster speeds and lower voltages than heretofore achieved. A higher interpoly dielectric breakdown capability and higher interpoly capacitance is required for VLSI technology due to the preferred smaller die size in high circuit density package. The invention involves the development of thinner and stronger interpoly dielectrics.

EPROM or EEPROM and methods for making the same are well known in the art. In general, an EPROM or an EEPROM is characterized by a "floating gate" and a electrical connection termed "control gate", both of which are fabricated out of polycrystalline silicon doped with an appropriate doping material to render the polycrystalline conductive. A typical doping material is phosphorus. The floating gate and the control gate are separated by a layer of insulating material, typically silicon dioxide ($SiO_2$). The principle upon which the EPROM or EEPROM device operates is that charges are stored on the "floating gate" in a capacitive manner. Thus, the dielectric of the layer of silicon dioxide between the floating gate and the control gate is important.

In the prior art (see for example, U.S. Patent No. 4,203,158 and W. S. Johnson et al. *ISCCC Digest of Technical Papers,*, pp. 152—153 (Feb., 1980)), the floating gate is formed by reacting $SiH_4$ in a low pressure chemical vapor deposition chamber and then doped with $POCl_3$. A layer of silicon dioxide is then deposited or thermally grown on the doped polycrystalline layer of silicon. The layer of silicon dioxide is typically approximately 7.5 nm (750 angstroms). Generally, a high oxidation temperature (greater than 1050°C) and heavier phosphorus doping are required to achieve better interpoly quality on breakdown capability. However, oxidation at high temperature on heavily-doped polysilicon involves several drawbacks, such as: (1) outgassing during interpoly oxidation which causes autodoping on wafer. (2) oxidation enhanced diffusion of phosphorus from the floating gate to the tunnel oxide, which, forms a trapping center in the oxide. The phosphorus induced trap collapses the threshold window of EEPROM cell at $10^4$ cycles. (See: R. B. Marcus et al., *J. Electrochem. Soc.,* p. 1282, June, 1982; K. Saraswat et al., *Computer-Aided Design of Integrated Circuit Fabrication Process for VLSI Device,* p. 244—290, July, 1981). Finally, the second layer of doped polycrystalline silicon is then formed on top of the insulating layer of $SiO_2$.

Because the insulating layer of silicon dioxide is on the order of 75 nm (750 angstroms), the typical write or erase voltage, i.e., the voltage which is needed to place charges on or to remove charges off the floating gate has been high, i.e, in excess of 20 volts, which places the shrinkage limits for gate oxide thickness, junction depth and die size.

Silicon nitride ($Si_3N_4$) has also been used as an insulating layer of dual dielectric (thermal oxide with silicon nitride on it) between the floating gate and the control gate connection. Silicon nitride has the property that it is more dense than silicon dioxide and, therefore, affords higher capacitive coupling between the floating gate and the control gate. A typical dual dielectric between the floating gate and the control gate is composed of 50 nm (500 angstroms) oxide and 40 nm (400 angstroms) nitride. However, even with the use of silicon nitride as the insulating layer, the write and erase voltage is still relatively high, in excess of 20 volts. This is due to the problem of asperity or roughness in the surface of the floating gate. Asperity in the floating gate causes points of electrical field enhancement. Thus, a large amount of insulating material must be interposed between the floating gate and the control gate. This, however, in turn, requires that a large voltage be used.

From US—A—3 996 657 there is known a method of making an electrically programmable memory device of the type having a control gate and a floating gate for storing charges therein, said method comprising the steps of fabricating a body of single crystalline semiconductive material having source and drain regions; thermally growing a first layer of insulating material on said body of semiconductive material; depositing a first layer of semiconductive material on said first layer of insulating material; diffusion doping said first layer of semiconductive material to form said floating gate; thermally growing a second layer of insulating material on said first layer of semiconductive material; and depositing a second layer of semiconductive material over said second layer of insulating material and forming said control gate.

Accordingly, it is the object of the invention to provide a method of this type with which the problem of asperity or roughness in the surface of the floating gate of the obtained memory device is removed allowing smaller amounts of insulating material to be interposed between the floating gate and the control gate, permitting a smaller voltage to be used for writing and erasing. As defined in the claims, this object is achieved by a method of the type known from US—A—3 996 657 in which the step of diffusion doping the first layer of semiconductive material to form the floating gate is replaced by ion implanting a doping material through said second layer of insulating material into said first layer of semiconductive material to form said floating gate.

Brief description of the drawings

Fig. 1 is an enlarged cross-sectional view of an EPROM device of the prior art and of the present invention.

Fig. 2 is an enlarged cross-sectional view of an EEPROM device of the prior art and of the present invention.

Fig. 3 is a cross-sectional view, greatly enlarged, of a section of the floating gate of the EPROM or EEPROM device of the prior art and a section of the floating gate of EPROM or EEPROM device of the present invention superimposed thereon.

Fig. 4 is an enlarged cross-sectional view of another EPROM device of the present invention.

Fig. 5 is an enlarged cross-sectional view of another EEPROM device of the present invention.

Fig. 6 is a graph showing current-voltage characteristics of a device of the prior art and of the present invention.

Detailed description of the drawings

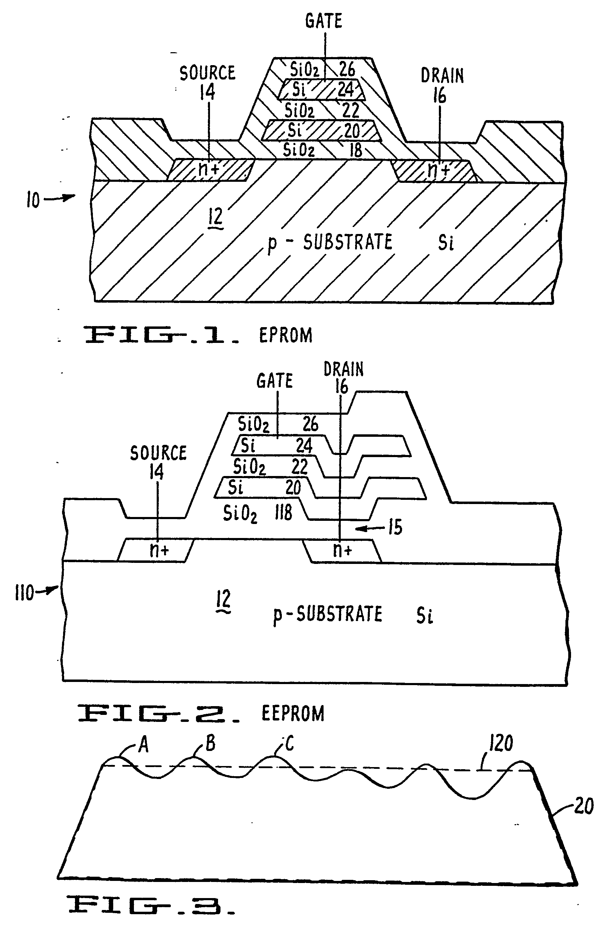

Referring to Fig. 1, there is shown an EPROM 10 of the prior art. The EPROM 10 comprises a substrate 12, which is typically a single crystalline silicon of the P type having a source 14 and a drain 16 fabricated therein. A first layer 18 of insulating material, typically $SiO_2$, is grown on the silicon substrate 12. The first layer 18 of $SiO_2$ is thermally grown at approximately 1,000 degree centigrade, using HCl and $O_2$. On the first layer 18 of $SiO_2$ is deposited and first layer 20 of polycrystalline silicon. The first layer 20 of polycrystalline 20 is deposited by low pressure chemical vapor deposition techniques. In a reaction chamber, $SiH_4$ is introduced and is reacted at approximately between 620—670 degrees centigrade, depositing the layer 20 of polycrystalline silicon. The first layer 20 of polycrystalline silicon is then doped by phosphorus, rendering it conductive to form the floating gate. Phosphorus is introduced into the reaction chamber in the form of $POCl_3$ at 950 degrees centigrade. A second layer 22 of insulating material, i.e., $SiO_2$, is thermally grown on the floating gate 20. The second layer 22 of $SiO_2$ is typically on the order of 75 to 100 nm (750 to 1000 angstroms). A second layer 24 of polycrystalline is deposited on the second layer 22 of $SiO_2$. The second layer 24 of polycrystalline silicon is doped to form the connection for the control gate of the EPROM 10.

Referring to Fig. 2, there is shown an EEPROM 110 of the prior art. The EEPROM 110 of the prior art is identical to the EPROM 10 of the prior art, shown in Fig. 1, except for the tunnel oxide region 15 between the drain 16 and the floating gate 20. The tunnel oxide region is typically approximately 10 nm (100 angstroms) thick. This narrow, thin tunnel oxide region 15 permits electrons to tunnel to or from the drain 16 during the erase or write cycle. The fabrication of the first layer 18 and second layer 22 of $SiO_2$ and the formation of the floating gate 20 and of the control gate 24 is similar to that described for the EPROM 10 of Fig. 1.

In the method of the present invention, the first layer 18 of $SiO_2$ is thermally grown on the single crystalline substrate 12 in the same manner as that for the EPROM 10 or the EEPROM 110 of the prior art. The floating gate 20, however, is formed by depositing a layer of polycrystalline silicon on the first layer 18 of $SiO_2$. The layer 20 of polycrystalline silicon is deposited by low pressure chemical vapor deposition technique in which $SiH_4$ is introduced and is reacted at approximately between 620—670 centigrade. The second layer 22 of $SiO_2$ is then thermally grown on the first layer 20 of undoped polycrystalline silicon. The second layer 22 of $SiO_2$ is approximately 25 nm (250 angstroms) thick. Phosphorus ions are then implanted in the first layer 20 of polycrystalline silicon through the second layer 22 of $SiO_2$. Typically, the phosphorus ions are accelerated at 70—120 KEV to impinge the second layer 22 of $SiO_2$, to pass therethrough and to be deposited in the first layer 20 of polycrystalline silicon. The first layer 20 of polycrystalline silicon, doped with the phosphorus, becomes the floating gate 20. $SiO_2$ can then be further deposited on top of the second layer 22 of $SiO_2$ to increase the total thickness to approximately 40—50 nm (400—500 angstroms). The second layer 24 of polycrystalline silicon is then deposited on the second layer 22 of silicon dioxide in the same manner as the prior art. The second layer 24 of polycrystalline can then be doped to be conductive to form the control gate.

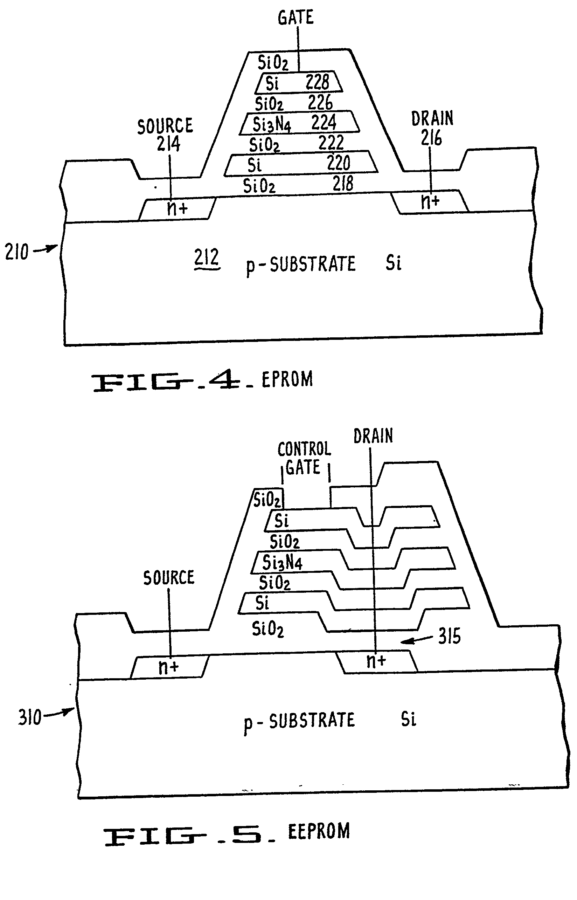

Referring to Fig. 3, there is shown a section of the floating gate 20 of the EPROM 10 or EEPROM 110 of the prior art (shown in solid line) and a section of the floating gate 120 of the EPROM or EEPROM made by the method of the present invention (shown in dotted lines). This is a greatly enlarged view, as typically the dimension of the floating gate is less than one micrometer in size.

As can be seen in Fig. 3, the floating gate 20 of the prior art shows a number of bumps (designated as A, B, C, etc.). The asperity in the floating gate 20 is attributable to the chemical phosphorus doping of the polycrystalline silicon. These bumps in the floating gate 20 form electrical field enhancement points. To prevent undesired discharge between the floating gate 20 and the control gate, the insulating layer therebetween or the second layer 22 of silicon dioxide must be relatively large (on the order of 75 nm (750 angstrom). Since

$$C = E \frac{A}{T},$$

where E is the dielectric constant of the material, A is the area between the two gates, and T is the thickness therebetween, for a large T, the value of C is reduced. Furthermore, since $\Delta Q = C \Delta V$ for a reduced value of C, a large Q of voltage V must be used to place the charge Q on or to remove it from the floating gate 20. Subsequently, the voltage to write or to erase must be large.

In contrast, with the floating gate 120 formed by the method of the present invention, the surface is relatively smooth. The doping material is not chemically introduced and does not deform the surface of the floating gate 120. Because the surface of the floating gate 120 is relatively smooth, the second layer 22 of silicon dioxide can be on the order of 40—50 nm (400—500 angstroms). This increases the capacitive coupling. Thus, the operating voltage for the write and erase cycles can be much lower.

The charging and discharging of the floating gate is accomplished by Fowler-Nordheim tunneling of electrons across the tunnel oxide. The tunnel current

$$J \text{ tunnel} = \alpha \cdot E^2 \cdot e^{-\beta/E}$$

where E is the electric field across the tunnel oxide, α and β are constants, electrical field

$$E = \frac{V}{t}$$

where V is the voltage drop across the tunnel oxide and t is the tunnel oxide thickness. V can be calculated from the capacitive equivalent voltage divider circuit.

If we define the coupling ratio as

$$\frac{V}{V \text{ applied,}}$$

during the charging state, the coupling ratio is

$$\frac{Cpp}{C \text{ total}}$$

where C total is the sum of interpoly capacitance (Cpp), gate oxide capacitance and tunnel oxide capacitance. Higher interpoly capacitance results in higher coupling ratio, which, results either in the reduction of charging state applied programming voltage or in shorter charging state programming time.

Referring to Fig. 4, there is shown a cross-sectional view of another EPROM 210 of the present invention. The EPROM 210 comprises a single crystalline silicon substrate 212, having a source 214 and a drain 216. A first layer 218 of SiO₂ is on the body 212. A first layer of undoped polycrystalline silicon 220 is on the first layer 218 of silicon dioxide. The first layer 220 is deposited by low pressure chemical vapor deposition technique of SiH at 620°C. The layer 220 is approximately between 300—450 nm (3000—4500 angstroms) thick. A second layer 222 of silicon dioxide is on the first layer 220 of polycrystalline silicon. The second layer 222 is substantially between 20—25 nm (200—250 angstroms). The second layer 220 is formed by thermal oxidation of dry O₂ at approximately 1000°C. The first layer 220 of polycrystalline silicon is doped with phosphorus that has been ion implanted through the second layer of 222 of silicon dioxide. $P^{31}$ is implanted at $1—5 \times 10^{15}/\text{cm}^2$ at 70—120 KEV.

Thereafter, the second layer 22 of silicon dioxide is bathed in sulfuric acid at 150°C for about 10 minutes. Then, the second layer 222 is dipped in a dilute HF acid for about 5 seconds to remove contamination due to the ion implantation. The HF acid removes approximately 2.5 nm (25 angstroms) of SiO₂. The dilute HF acid comprises ten parts of distill water to one part of HF acid. The second layer 222 is then rinsed in distilled water and dried. A third layer 224 of insulating material is deposited on the second layer 222 of silicon dioxide. The third layer 224 comprises silicon nitride (Si₃N₄) and is deposited by low pressure chemical vapor deposition technique. NH₃ and SiH₂Cl₂ are reacted at approximately 770°C. The third layer 224 is approximately 25 nm (250 angstroms). A pyrogenic oxidation (H₂/O₂) cycle is then performed to reduce the nitride pinhole and nitride/oxide interface state. The pyrogenic oxidation step is accomplished by reacting H₂ and O₂ at 900°C for about 2 hours. This automatically produces the third layer 226 of SiO₂ which is between approximately 3—5 nm (30—50 angstroms). Finally, the second layer 228 of polycrystalline silicon is then deposited on the third layer 226 of SiO₂. The second layer 228 of polycrystalline silicon is then doped to form the control gate.

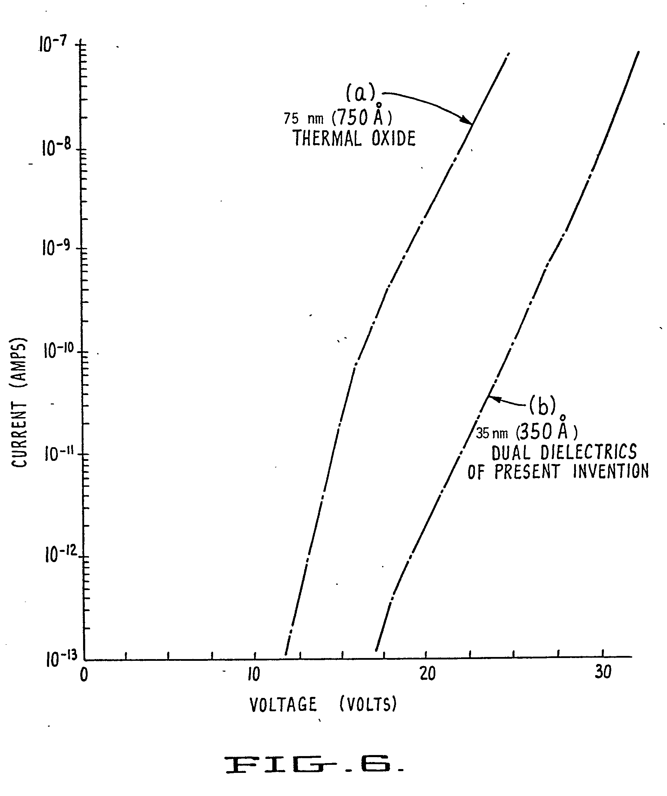

Referring to Fig. 5, there is shown another EEPROM 310 of the present invention. The EEPROM 310 of the present invention is identical to the EPROM 210 shown in Fig. 4, except with the addition of a tunnel oxide region 315. In all other respects, the first, second, and third layers of insulating material (comprising the two layers of SiO₂ and one layer of Si₃N₄) and the two layers of polycrystalline silicon are identical to the similar structures for the EPROM 210 and are made in the same manner. The first layer of SiO₂ is approximately 75 nm (750 angstroms) thick over the thick gate region and is approximately 10 nm (100 angstroms) thick in the tunnel oxide region.

With the EPROM 210 or the EEPROM 310, there is greater capacitive coupling between the control gate and the floating gate due to the silicon nitride deposited therebetween. Since silicon nitride has a higher dielectric constant, the capacitance is increased. This means that a lower operating voltage, on the order of 12 volts, can be used to write or to erase charges from the floating gate 220.

**Claims**

1. A method of making an electrically programmable memory device (10, 110, 210, 310) of the type having a control gate (24, 228) and a floating gate (20, 220) for storing charges therein, said method comprising the steps of
   fabricating a body (12, 212) of single crystalline semiconductive material having source (14, 214) and drain (16, 216) regions;
   thermally growing a first layer (18, 118, 218) of insulating material on said body (12, 212) of semiconductive material;
   depositing a first layer (20, 220) of semiconductive material on said first layer (18, 118, 218) of insulating material;

thermally growing a second layer (22, 222) of insulating material on said first layer (20, 220) of semiconductive material;

ion implanting a doping material through said second layer (22, 222) of insulating material into said first layer (20, 220) of semiconductive material to form said floating gate; and

depositing a second layer (24, 228) of semiconductive material over said second layer (22, 222) of insulating material and forming said control gate.

2. The method of Claim 1, wherein said body (12, 212), of single crystalline semiconductive material and said first (20, 220) and second (24, 228) layers of semiconductive material are of silicon.

3. The method of Claim 2, wherein said first (20, 210) and second (24, 228) layers of silicon are polycrystalline silicon.

4. The method of Claim 2, wherein said first (18, 118, 218) and second (22, 222) layers of insulating material are of silicon dioxide ($SiO_2$).

5. The method of Claim 3, wherein said first (20, 220) layer of polycrystalline silicon is deposited by low pressure chemical vapor deposition.

6. The method of Claim 5, wherein said doping material is phosphorus.

7. The method of any one of Claims 1 to 6 after said implanting step further comprising the steps of

removing a portion of said second layer (222) of insulating material; and

depositing a third layer (224) of insulating material on said second layer (222) of insulating material;

wherein said second layer (228) of conductive material being deposited on said third layer (224) of insulating material.

8. The method of Claim 7, wherein said third layer (224) of insulating material is $Si_3N_4$.

9. The method of Claim 7 when appended to claim 4, wherein said removing step comprises exposing said second layer (222) of $SiO_2$ to dilute HF acid.

10. The method of Claim 9 further comprising the step of exposing said third layer (224) of insulating material to pyrogenic ($H_2/O_2$) oxidation, forming a fourth layer (226) of insulating material of $SiO_2$.

11. The method of Claim 10, wherein said depositing step for the first layer (220) of polycrystalline silicon forms a layer thickness of approximately 300—400 nm; said depositing step for the second layer (222) of $SiO_2$ forms a layer thickness of substantially 25 nm; said removing step removes substantially 2 nm of $SiO_2$; said depositing step for the third layer (224) of $Si_3N_4$ forms a layer thickness of substantially 25 nm; and said fourth layer (226) is substantially 3—5 nm thick.

## Patentansprüche

1. Verfahren zur Herstellung einer elektrisch programmierbaren Speicheranordnung (10, 110, 210, 310), welche eine Gatezone (24, 228) und eine zur Ladungsspeicherung dienende schwimmende Gatezone (20, 220) aufweist, mit folgenden Verfahrensschritten:

Herstellen eines Körpers (12, 212) aus einkristallinem Halbleitermaterial, der eine Sourcezone (14, 214) und eine Drainzone (16, 216) aufweist;

thermisches Aufwachsen einer ersten Isolationsschicht (18, 118, 218) auf den Körper (12, 212) aus Halbleitermaterial;

Abscheiden einer ersten Schicht (20, 220) aus Halbleitermaterial auf die erste Isolationsschicht (18, 118, 218);

thermisches Aufwachsen einer zweiten Isolationsschicht (22, 222) auf die ershe Schicht (20, 220) aus Halbleitermaterial;

Ionenimplantation eines Dotierstoffes durch die zweite Isolationsschicht (22, 222) in die erste Schicht (20, 220) aus Halbleitermaterial, um die schwimmende Gatezone (20, 220) zu bilden; und

Abscheiden einer zweiten Schicht (24, 228) aus Halbleitermaterial auf der zweiten Isolationsschicht (22, 222), um die Gatezone (24, 228) zu bilden.

2. Verfahren nach Anspruch 1, bei dem der einkristalline Halbleiterkörper (12, 212) sowie die erste (20, 220) und die zweite (24, 228) Schicht aus Silicium sind.

3. Verfahren nach Anspruch 2, bei dem die erste (20, 220) und die zweite (24, 228) Siliciumschicht polykristallines Silicium sind.

4. Verfahren nach Anspruch 2, bei dem die erste (18, 118, 218) und die zweite (22, 222) Isolationsschicht aus Siliciumdioxid ($SiO_2$) besteheb.

5. Verfahren nach Anspruch 3, bei dem die erste polykristalline Siliciumschicht (20, 220) durch ein chemisches Gasabscheidungsverfahren bei niedrigem Druck gebildet wird.

6. Verfahren nach Anspruch 5, bei dem der Dotierungsstoff Phosphor ist.

7. Verfahren nach einem der Ansprüche 1 bis 6, bei dem der Implantationsverfahrensschritt folgende Schritte umfaßt:

Entfernen eines Teiles der zweiten Isolationsschicht (222);

Abscheiden einer dritten Isolationsschicht (224) auf der zweiten Isolationsschicht (222),

so daß die zweite Halbleiterschicht (228) auf der dritten Isolationsschicht (224) abgeschieden wird.

8. Verfahren nach Anspruch 7, bei dem die dritte Isolationsschicht $Si_3N_4$ ist.

9. Verfahren nach Anspruch 7 und 4, bei dem der Entfernungsschritt darin besteht, daß die zweite Schicht (222) aus $SiO_2$ einer dünnflüssigen HF-Säure ausgesetzt wird.

10. Verfahren nach Anspruch 9, mit dem Verfahrensschritt, daß die dritte Isolationsschicht (224) einer pyrogenen ($H_2/O_2$) Oxidation ausgesetzt wird und daraus eine vierte Isolationsschicht (226) aus $SiO_2$ gebildet wird.

11. Verfahren nach Anspruch 10, bei dem der Abscheideschritt eine erste polykristalline Siliciumschicht (220) mit einer größeren Dicke von etwa 300 bis 400 nm bildet;

der Abscheideschritt eine zweite Schicht (222) aus SiO$_2$ mit einer größeren Dicke von etwa 25 nm bildet;

der Entfernungsschritt eine Schicht von etwa 2 nm SiO$_2$ abträgt;

der Abscheideschritt eine dritte Schicht (224) aus Si$_3$N$_4$ mit einer größeren Dicke von etwa 25 nm bildet; und

die vierte Schicht (226) etwa 3 bis 5 nm dick ist.

## Revendications

1. Procédé de fabrication d'un dispositif de mémoire électriquement programmable (10, 110, 210, 310) du type comportant une grille de commande (24, 228) et une grille flottante (20, 220) destinée à stocker des charges, ledit procédé comprenant les étapes qui consistent.

à fabriquer un corps (12, 212) de matière semi-conductrice monocristalline ayant des régions de source (14, 214) et de drain (16, 216);

à faire croître thermiquement une première couche (18, 118, 218) de matière isolante sur ledit corps (12, 212) de matière semi-conductrice;

à déposer une première couche (20, 220) de matière semi-conductrice sur ladite première couche (18, 118, 218) de matière isolante;

à faire croître thermiquement une seconde couche (22, 222) de matière isolante sur ladite première couche (20, 220) de matière semi-conductrice;

à introduire par implantation ionique une matière dopante, à travers ladite seconde couche (22, 222) de matière isolante, dans ladite première couche (20, 220) de matière semi-conductrice pour former ladite grille flottante; et

à déposer une seconde couche (24, 228) de matière semi-conductrice sur ladite seconde couche (22, 222) de matière isolante et à former ladite grille de commande.

2. Procédé selon la revendication 1, dans lequel ledit corps (12, 212) de matière semi-conductrice monocristalline et lesdites première (20, 220) et seconde (24, 228) couches de matière semi-conductrice sont en silicium.

3. Procédé selon la revendication 2, dans lequel lesdites première (20, 220) et seconde (24, 228) couches de silicium sont en silicium polycristallin.

4. Procédé selon la revendication 2, dans lequel lesdits première (18, 118, 218) et seconde (22, 222) couches de matière isolante sont en dioxyde de silicium (SiO$_2$).

5. Procédé selon la revendication 3, dans lequel ladite première couche (20, 220) de silicium polycristallin est déposée par dépôt chimique en phase vapeur à basse pression.

6. Procédé selon la revendication 5, dans lequel ladite matière dopante est du phosphore.

7. Procédé selon l'une quelconque des revendications 1 à 6, comprenant en outre, après ladit étape d'implantation, les étapes qui consistent

à enlever une partie de ladite seconde couche (222) de matière isolante; et

à déposer une troisème couche (224) de matière isolante sur ladite seconde couche (222) de matière isolante;

ladite seconde couche (228) de matière conductrice étant déposée sur ladite troisième couche (224) de matière isolante.

8. Procédé selon la revendication 7, dans lequel ladite troisième couche (224) de matière isolante est en Si$_3$N$_4$.

9. Procédé selon la revendication 7 ou dépendance de la revendication 4, dans lequel ladite étape d'enlèvement consiste à exposer ladite seconde couche (222) de SiO$_2$ à de l'acide HF dilué.

10. Procédé selon la revendication 9, comprenant en outre l'étape qui consiste à exposer ladite troisième couche (224) de matière isolante à une oxydation pyrogénique (H$_2$/O$_2$), formant une quatrième couche (226) de matière isolante en SiO$_2$.

11. Procédé selon la revendication 10, dans lequel ladite étape de dépôt pour la première couche (220) de silicium polycristallin forme une couche d'une épaisseur d'environ 300—400 nm; ladite étape de dépôt de la deuxième couche (222) de SiO$_2$ forme une couche d'une épaisseur d'environ 25 nm, ladite étape d'enlèvement enlève sensiblement 2 nm de SiO$_2$, ladite étape de dépôt pour la troisième couche (224) de Si$_3$N$_4$ forme une couche d'une épaisseur d'environ 25 nm; et ladite quatrième couche (226) est sensiblement de 3—5 nm d'épaisseur.

**FIG.1.** EPROM

**FIG.2.** EEPROM

**FIG.3.**

GATE

SiO₂
| Si | 228 |
SiO₂ | 226
| Si₃N₄ | 224 |
SiO₂ | 222
| Si | 220 |
SiO₂ | 218

SOURCE
214

DRAIN
216

n+          n+

210 →

212   p-SUBSTRATE   Si

**FIG.4.** EPROM

CONTROL
GATE    DRAIN

SiO₂
Si
SiO₂
Si₃N₄
SiO₂
Si
SiO₂

SOURCE

n+          n+

← 315

310 →

p-SUBSTRATE   Si

**FIG.5.** EEPROM

FIG.6.